(19) Europäisches Patentamt / European Patent Office / Office européen des brevets

(11) **EP 3 682 368 B1**

(12) **FASCICULE DE BREVET EUROPEEN**

(45) Date de publication et mention de la délivrance du brevet:
**10.07.2024 Bulletin 2024/28**

(21) Numéro de dépôt: **18780177.4**

(22) Date de dépôt: **10.09.2018**

(51) Classification Internationale des Brevets (IPC):
**G06F 18/213** (2023.01)   **G06F 18/24** (2023.01)
**H01M 8/04992** (2016.01)

(52) Classification Coopérative des Brevets (CPC):
G01R 31/367; G06F 18/2411; G06F 18/2433;
G06F 2218/08; G06F 2218/12; H01M 8/04664;
H01M 8/04992; Y02E 60/50

(86) Numéro de dépôt international:
**PCT/FR2018/052207**

(87) Numéro de publication internationale:
**WO 2019/048803 (14.03.2019 Gazette 2019/11)**

(54) **MÉTHODE DE DÉTERMINATION DU RÉGIME DE FONCTIONNEMENT D'UN SYSTÈME, MÉTHODE DE CONFIGURATION D'UN CLASSIFIEUR SERVANT A IDENTIFIER UN TEL RÉGIME, ET DISPOSITIF DE DÉTERMINATION D'UN TEL RÉGIME**

VERFAHREN ZUR BESTIMMUNG DES BETRIEBSZUSTANDES EINES SYSTEMS, VERFAHREN ZUM KONFIGURIEREN EINES KLASSIERERS ZUR IDENTIFIZIERUNG EINES SOLCHEN ZUSTANDES UND VORRICHTUNG ZUR BESTIMMUNG EINES SOLCHEN ZUSTANDES

METHOD FOR DETERMINING THE OPERATING STATE OF A SYSTEM, METHOD FOR CONFIGURING A CLASSIFIER USED TO IDENTIFY SUCH A STATE, AND DEVICE FOR DETERMINING SUCH A STATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.09.2017 FR 1758348**

(43) Date de publication de la demande:
**22.07.2020 Bulletin 2020/30**

(73) Titulaire: **Université Gustave Eiffel 77454 Marne-la-Vallée Cedex 2 (FR)**

(72) Inventeurs:
• **BENOUIOUA, Djedjiga 90400 Danjoutin (FR)**
• **CANDUSSO, Denis 90850 Essert (FR)**
• **HAREL, Fabien 90200 Giromagny (FR)**
• **PICARD, Pierre 94300 Vincennes (FR)**

(74) Mandataire: **Cabinet Beau de Loménie 158, rue de l'Université 75340 Paris Cedex 07 (FR)**

(56) Documents cités:
• **WEI LIU ET AL: "Application of Hilbert-Huang Transform and SVM to Coal Gangue Interface Detection", JOURNAL OF COMPUTERS, vol. 6, no. 6, 3 June 2011 (2011-06-03), FI, XP055473843, ISSN: 1796-203X, DOI: 10.4304/jcp.6.6.1262-1269**
• **MICHAEL FELDMAN: "Hilbert Transform Applications in Mechanical Vibration", 1 January 2011, WILEY, pages: 9 - 21, 130, XP055473973**
• **D. BENOUIOUA ET AL: "Multifractal Analysis of Stack Voltage Based on Wavelet Leaders: A New Tool for PEMFC Diagnosis", FUEL CELLS, vol. 17, no. 2, 14 July 2016 (2016-07-14), DE, pages 217 - 224, XP055474007, ISSN: 1615-6846, DOI: 10.1002/fuce.201600029**

- **LU DINGGUO ET AL: "Adaptive feature extraction and SVM classification for real-time fault diagnosis of drivetrain gearboxes", 2013 IEEE ENERGY CONVERSION CONGRESS AND EXPOSITION, IEEE, 15 September 2013 (2013-09-15), pages 3934 - 3940, XP032516188, DOI: 10.1109/ECCE.2013.6647222**
- **LI ZHONGLIANG ET AL: "Data-driven diagnosis of PEM fuel cell: A comparative study", CONTROL ENGINEERING PRACTICE, vol. 28, 27 March 2014 (2014-03-27), pages 1 - 12, XP028651943, ISSN: 0967-0661, DOI: 10.1016/J.CONENGPRAC.2014.02.019**
- **LU DINGGUO ET AL: "Adaptive feature extraction and SVM classification for real-time fault**

## Description

Méthode de détermination du régime de fonctionnement d'un système, méthode de configuration d'un classifieur servant à identifier un tel régime, et dispositif de détermination d'un tel régime.

DOMAINE DE L'INVENTION

L'invention se place dans le domaine de la reconnaissance de formes et le domaine du traitement des signaux.
Elle concerne une méthode de configuration d'un classifieur servant à identifier le régime de fonctionnement d'un système, une méthode et un dispositif de détermination du régime de fonctionnement d'un système, en particulier dans le cas où le système est un système électrochimique tel qu'une pile à combustible. Par 'classifieur', on désigne ici un dispositif de calcul, par exemple un ordinateur, apte, à partir de données représentant un état et/ou un régime de fonctionnement d'un système, à identifier l'état ou le régime de fonctionnement dans lequel le système se trouvait lorsque lesdites données ont été acquises.

ARRIERE-PLAN DE L'INVENTION

Les systèmes électrochimiques, qui sont les systèmes pour lesquels l'invention a été initialement conçue, sont des systèmes comprenant un milieu dans lequel une réaction ou un phénomène chimique qui se produit est couplé à des échanges d'énergie électrique. Les systèmes électrochimiques incluent notamment les systèmes d'électrolyse ou d'électrodéposition, les piles électriques, les piles à combustibles, les accumulateurs et les supercondensateurs.
La durée de vie et la fiabilité de ces systèmes sont importantes pour les utilisateurs de ces systèmes. Notamment, dans le cas des piles à combustible, la durabilité et la fiabilité des systèmes à pile à combustible sont l'un des enjeux majeurs des développements actuels, tant pour les applications de transport (au moins 5 000 h de fonctionnement en sollicitations dynamiques pour l'automobile) que pour les applications stationnaires (objectif : 40 000 h à 60 000 h de fonctionnement).
Il existe donc un besoin pour des méthodes et des dispositifs de diagnostic permettant de déterminer le régime de fonctionnement de systèmes électrochimiques, dans le but d'identifier au plus tôt les défaillances affectant ces systèmes.
Différentes méthodes ont été développées pour répondre à ce besoin.
Des méthodes de caractérisation électrochimique telles que la méthode par courbe de polarisation, la méthode d'interruption de courant et la Spectroscopie d'Impédance Electrochimique (SIE) ont ainsi été utilisées pour le diagnostic des accumulateurs et convertisseurs d'énergie. Cependant, ces méthodes présentent des limitations pour les applications en temps réel. Elles nécessitent en effet des contrôles et des sollicitations précises sur le courant ou la tension, ainsi que des équipements supplémentaires souvent coûteux et volumineux.
D'autres méthodes de diagnostic, parfois appelées « méthodes internes », se fondent sur une modélisation du système électrochimique étudié. Cependant, cette modélisation nécessite un travail préalable important. De plus, souvent, la complexité des phénomènes physico-chimiques rend leur modélisation difficile, ce qui entraîne une faible précision ou fiabilité de ces méthodes.
Enfin, des méthodes exploitant des outils de traitement du signal ont également été utilisées pour extraire des indices sur l'état de santé de piles à combustible. Cependant, ces méthodes exploitent les signaux acquis par un nombre élevé de capteurs. Ces méthodes nécessitent donc le traitement de quantités d'informations considérables. Elles sont complexes à mettre en oeuvre et nécessitent des ressources en calcul importantes.
Une méthode d'analyse des tensions de sortie de piles à combustible est ainsi divulguée par le document « Multifractal Analysis of Stack Voltage BAsed on Wavelet Leaders : A new tool for PEMFC Diagnosis », de Mme Benouioua, MM.D.Candusso, F.Harel et L.Oukhellou, in Fuell Cells, vol.17, no.2, 14 juillet 2016, pages 217-224.
Par ailleurs, dans un domaine distinct, celui de la mécanique, des méthodes de reconnaissance de formes et de traitement des signaux sont proposées par les documents :

« Applications of Hilbert-Hugon Transform and SVM to Coal Gangue Interface Détection », de Wei Liu et al., in Journal of computers, vol.6, no.6, 3 juin 2011 ;
« Adaptive feature extraction and SVM classification for real-time diagnosis of drivetrain gearboxes », de Lu Dingguo et al., in 2013 IEEE Energy Conversion Congress and Exposition, 15 septembre 2013, pages 3934-3940.

OBJET ET RESUME DE L'INVENTION

Par suite, un premier objectif de l'invention est de remédier aux inconvénients des méthodes de détermination du régime de fonctionnement de systèmes électrochimiques connues et de proposer une méthode de détermination du régime de fonctionnement de systèmes, notamment de systèmes électrochimiques, qui permette d'identifier le régime de fonctionnement du système parmi une pluralité de régimes de fonctionnement prédéterminés dudit système, qui soit relativement simple, tant en ce qui concerne l'acquisition des informations nécessaires au diagnostic qu'en ce qui concerne le traitement de ces informations.

Pour atteindre cet objectif, selon la présente invention il est tout d'abord proposé une méthode de détermination d'un régime de fonctionnement d'un système. Cette méthode peut notamment être utilisée comme méthode de diagnostic, pour détecter que le système est dans un mode de fonctionnement anormal ou du moins non souhaité, afin de déclencher les actions correctives nécessaires.

Mais de plus, comme cette méthode de détermination fait appel à un classifieur pour identifier le régime de fonctionnement du système parmi un certain nombre de régimes de fonctionnement prédéterminés, selon l'invention, il est proposé une méthode de configuration du classifieur utilisé dans la méthode de diagnostic indiquée précédemment.

Ces différentes méthodes sont toutes destinées à être mises en oeuvre par ordinateur.

La méthode de détermination d'un régime de fonctionnement d'un système comprenant une pile à combustible, selon l'invention, est définie par la revendication 4.

La méthode est appliquée à un système comprenant une pile à combustible et la variable est une tension mesurée à des bornes de la pile à combustible

Le classifieur peut notamment exécuter un algorithme de classification de type SVM (de l'anglais 'Support Vector Machine' ou en français machines à vecteurs de support ou séparateurs à vaste marge) de type multi-classes.

La variable peut être une variable scalaire ou vectorielle. Il peut s'agir par exemple d'une seule grandeur, par exemple une mesure de tension, de pression, d'intensité de courant électrique, ou autre.

Avantageusement, la méthode permet donc d'identifier le régime de fonctionnement du système simplement à partir des valeurs d'un vecteur de valeurs acquises, c'est-à-dire à partir d'une série de valeurs de la variable étudiée.

Il s'est avéré en effet que sur la base d'un vecteur de descripteurs statistiques de la variable étudiée, d'un vecteur de descripteurs statistiques des enveloppes instantanées de cette variable, et d'un vecteur de descripteurs statistiques des fréquences instantanées de cette variable, il est possible, en utilisant un classifieur configuré de manière approprié, d'identifier le régime de fonctionnement du système considéré avec une fiabilité tout-à-fait acceptable.

La méthode proposée est particulièrement adaptée pour déterminer le régime de fonctionnement d'un système, notamment un système électrochimique comprenant une pile à combustible. La variable indiquée précédemment peut alors être par exemple la tension mesurée aux bornes de la pile à combustible.

La méthode peut être appliquée à des systèmes de toute nature, et notamment à des systèmes électrochimiques, mais les revendications ne portent que sur les systèmes à pile à combustible.

Dans la méthode proposée, le calcul des vecteurs d'enveloppes instantanées et de fréquences instantanées peut se faire de différentes manières.

Dans un mode de mise en oeuvre, l'étape de calcul de vecteurs d'enveloppes instantanées et de fréquences instantanées comporte les étapes suivantes :

- on calcule la transformée de Hilbert H(x(n)) du vecteur de valeurs acquises x(n).
- on calcule le signal analytique complexe Zx(n) à partir de la transformée de Hilbert H(x(n)) ainsi calculée, en utilisant la formule :

$$Zx(n) = x(n) + jH(x(n))$$

- on calcule alors le vecteur d'enveloppes instantanées (ex(n)) et le vecteur de fréquences instantanées (fx(n)) à partir du signal analytique complexe Zx(n) ainsi calculé.

Une fois calculés le vecteur d'enveloppes instantanées et le vecteur de fréquences instantanées, le calcul de descripteurs statistiques, respectivement pour ces trois vecteurs, peut être réalisé. Les descripteurs statistiques utilisés dans le vecteur de valeurs acquises, le vecteur d'enveloppes instantanées et le vecteur de fréquences instantanées ne sont pas nécessairement les mêmes mais ils peuvent être les mêmes.

Dans un mode de mise en oeuvre, les descripteurs statistiques d'un des vecteurs de descripteurs statistiques calculés, et éventuellement de ces trois vecteurs, sont un ou plusieurs descripteurs statistiques choisis parmi la moyenne, la variance, la médiane, le kurtosis, le maximum, le minimum, l'écart-type et le coefficient de variation. (Une définition de ces descripteurs est donnée plus loin).

En particulier les descripteurs statistiques d'un des vecteurs de descripteurs statistiques calculés, et éventuellement de ces trois vecteurs, peuvent être précisément la moyenne, la variance, la médiane, le kurtosis, le maximum, le minimum, l'écart-type et le coefficient de variation.

Une méthode pour faire et pour optimiser le choix des descripteurs statistiques utilisés est indiquée plus loin.

Une fois calculés les trois vecteurs de descripteurs statistiques respectivement pour le vecteur de valeurs acquises, le vecteur d'enveloppes instantanées, et le vecteur de fréquences instantanées, le régime de fonctionnement du système peut être identifié à l'aide d'un classifieur approprié.

Tout classifieur permettant, à partir des trois vecteurs de descripteurs statistiques respectivement pour le vecteur de valeurs acquises, le vecteur d'enveloppes instantanées, et le vecteur de fréquences instantanées, d'identifier le régime de fonctionnement du système, peut être utilisé. Avantageusement, le classifieur en général n'est pas fondé sur un modèle, et d'autre part, il peut fournir sa réponse sans qu'il soit nécessaire de soumettre le système à une sollicitation particulière.

Dans un mode de réalisation, le classifieur est un classifieur à apprentissage automatique, et l'opération de configuration réalisée est une opération d'apprentissage automatique ou apprentissage machine.

Une telle opération consiste à fixer les valeurs de différents paramètres utilisés par le programme informatique de calcul. Cette opération d'apprentissage machine est normalement réalisée à partir d'une base de données associant d'une part, des valeurs de triplets vecteurs de descripteurs statistiques respectivement pour le vecteur de valeurs acquises, le vecteur d'enveloppes instantanées et le vecteur de fréquences instantanées au régime de fonctionnement dans lequel était le système lorsque les valeurs de la variable considérée ont été acquises.

Dans un mode de réalisation, le classifieur est un classifieur apte à mettre en oeuvre un algorithme de type 'Supports Vectors Machines' multiclasses, ou apte à mettre en oeuvre la méthode 'des k plus proches voisins', ou la méthode 'Gaussian mixture model' (GMM).

Les algorithmes de type 'Supports Vectors Machines' sont des algorithmes fondés sur la recherche de l'hyperplan de marge optimale. Le principe de la maximisation de la marge est formulé de sorte à choisir un hyperplan optimal qui doit maximiser la distance entre la frontière de séparation et les points de chaque classe qui lui sont les plus proches.

La méthode des 'k plus proches voisins' consiste à étiqueter un nouvel échantillon par l'étiquette majoritaire dans ses k-plus proches voisins.

La méthode 'Gaussian Mixture Model', ou GMM, est une approche probabiliste, utilisée pour estimer les paramètres d'une distribution de variables aléatoires en les modélisant par une densité de mélange. Chaque composant du mélange caractérise une classe.

D'autre part, le classifieur est de préférence un classifieur configuré par la méthode de configuration de classifieur selon l'invention, mise en oeuvre à l'aide d'un ordinateur, qui va maintenant être présentée.

La méthode de configuration de classifieur selon l'invention est une méthode de configuration d'un classifieur pour rendre celui-ci apte à déterminer un régime de fonctionnement d'un système parmi une pluralité de régimes de fonctionnement prédéterminés dudit système.

Cette méthode est la méthode définie par la revendication 1.

La méthode est appliquée à un système comprenant une pile à combustible, et la variable est une tension mesurée à des bornes de la pile à combustible

Lors de l'étape S30, les valeurs acquises sont acquises lorsque le système est dans le régime de fonctionnement considéré.

Pour la mise en oeuvre des méthodes selon l'invention, les descripteurs statistiques utilisés peuvent être choisis de différentes manières.

Par défaut, on peut utiliser un nombre de descripteurs statistiques relativement grand. Par exemple, on peut éventuellement calculer des vecteurs de valeurs de descripteurs statistiques pour l'ensemble des descripteurs statistiques cités dans la table ci-dessous.

| Paramètres statistique | Equation |
|---|---|
| Moyenne | $x_m = \sum_{n=1}^{N} \frac{x(n)}{N}$ |
| Ecart type | $\sigma = \sqrt{\dfrac{\sum_{n=1}^{N}(x(n) - x_m)^2}{N}}$ |
| Variance | $x_{var} = \dfrac{\sum_{n=1}^{N}(x(n) - x_m)^2}{N}$ |

(suite)

| Paramètres statistique | Equation |
|---|---|
| Valeur efficace (RMS) | $$x_{eff} = \sqrt{\frac{\sum_{n=1}^{N}\left(x(n)\right)^2}{N}}$$ |
| Amplitude maximale | $$x_{max} = max|x(n)|$$ |
| Amplitude minimale | $$x_{min} = min|x(n)|$$ |
| Biais | $$x_{ske} = \frac{\sum_{n=1}^{N}(x(n) - x_m)^3}{(N-1)\sigma^3}$$ |
| Kurtosis | $$x_{kur} = \frac{\sum_{n=1}^{N}(x(n) - x_m)^4}{(N-1)\sigma^4}$$ |
| Facteur de crête CF | $$CF = \frac{x_{max}}{x_{eff}}$$ |
| Facteur de clairance CLF | $$CLF = \frac{x_{max}}{\left(\frac{1}{N}\sum_{n=1}^{N}\sqrt{|x(n)|}\right)^2}$$ |
| Facteur de forme SF | $$SF = \frac{x_{eff}}{\frac{1}{N}\sum_{n=1}^{N}|x(n)|}$$ |
| Facteur d'impulsion IF | $$IF = \frac{x_{max}}{\frac{1}{N}\sum_{n=1}^{N}|x(n)|}$$ |
| Déviation absolue moyenne MAD | $$MAD = \sum_{n=1}^{N}\frac{|\sum_{n=1}^{N}(x(n) - x_m)|}{N}$$ |
| MOMENT Central MC | $$MC = \sum_{n=1}^{N}\frac{\sum_{n=1}^{N}(x(n)-x_m)^p}{N}$$ $$p = 1, 2 \ldots \ldots$$ |
| Etendue | $$x_{range} = |x_{max} - x_{min}|$$ |
| Médiane | |
| Coefficient de variation CY | $$CV = \frac{\sigma}{x_m}$$ |

Cependant, il est préférable d'optimiser le choix des descripteurs statistiques.

Dans ce but, parmi tous les descripteurs statistiques envisageables, on commence alors par identifier un sous-ensemble de descripteurs statistiques particulièrement pertinents pour identifier un régime de fonctionnement du système considéré parmi les régimes de fonctionnement prédéterminés. Ce sous-ensemble comporte les descripteurs statistiques particulièrement pertinents pour le vecteur des variables acquises, les descripteurs statistiques particulièrement pertinents pour le vecteur des enveloppes instantanées des variables acquises, et les descripteurs statistiques particulièrement pertinents pour le vecteur des fréquences instantanées des variables acquises.

Ensuite, une fois que ce sous-ensemble de descripteurs statistiques particulièrement pertinents a été identifié, on utilise dès lors uniquement les descripteurs statistiques de ce sous-ensemble de descripteurs statistiques dans le cadre de l'invention : on calcule des vecteurs de descripteurs statistiques uniquement pour ces sous-ensembles de descripteurs statistiques ; ensuite, on met en oeuvre comme classifieur de données un classifieur de données prévu pour déterminer le régime de fonctionnement du système parmi les régimes de fonctionnement prédéterminés du système à partir de valeurs issues seulement du sous-ensemble de descripteurs statistiques ainsi identifié.

Dans la définition ci-dessus, le « sous-ensemble de descripteurs statistiques particulièrement pertinents pour identifier un régime de fonctionnement d'un système parmi les régimes de fonctionnement prédéterminés » désigne un ensemble de descripteurs statistiques contenant moins de descripteurs que le nombre initial de descripteurs envisagés et tel qu'il soit possible en fonction uniquement des descripteurs statistiques de ce sous-ensemble d'identifier le régime de fonctionnement du système considéré parmi ladite pluralité de régimes de fonctionnement prédéterminés, avec un taux d'erreur considéré comme acceptable. Cette opération d'identification peut être réalisée en mettant en oeuvre un algorithme de type mRMR ou 'Wrapper'.

La méthode mRMR est une méthode de filtrage fondée sur le calcul de mesures statistiques classiques comme l'information mutuelle, la corrélation, etc..., qui permet de mesurer la dépendance statistique d'une variable par rapport à une autre. A partir de cette mesure, on cherche à satisfaire deux critères : minimiser la redondance (mR) et maximiser la pertinence (MR) entre les variables.

La stratégie 'Wrapper' quant à elle cherche à optimiser un critère de performance optimisé par le calcul du score de la classification. Son principe est de générer des sous-ensembles de candidats et de les évaluer grâce à un algorithme de classification.

Dans un mode particulier de réalisation, les différentes étapes de la méthode de détermination de régime de fonctionnement d'un système ou de la méthode de configuration de classifieur selon l'invention sont déterminées par des instructions de programmes d'ordinateurs.

En conséquence, l'invention vise aussi un programme d'ordinateur sur un support d'informations, ce programme étant susceptible d'être mis en oeuvre dans un ordinateur, ce programme comportant des instructions de code de programme pour l'exécution des étapes de la méthode de détermination de régime de fonctionnement d'un système ou de la méthode de configuration de classifieur définie précédemment lorsque ledit programme est exécuté sur un ordinateur.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable. Le programme selon l'invention peut être en particulier téléchargé sur un réseau de type Internet.

L'invention vise aussi un support d'informations non volatiles lisible par un ordinateur, sur lequel est enregistré un programme d'ordinateur tel que défini ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une clef USB ou un disque dur.

Alternativement, le support d'informations peut être un circuit intégré dans lequel le programme est incorporé, le circuit étant adapté pour exécuter ou pour être utilisé dans l'exécution de la méthode de diagnostic ou de la méthode de configuration de classifieur décrites précédemment.

L'invention vise aussi un classifieur configuré par la méthode de configuration de classifieur définie précédemment.

L'invention vise également un système électrochimique tel que défini par la revendication 11, qui comprend une pile à combustible et est équipé d'un dispositif de détermination pour déterminer un régime de fonctionnement du système.

Ce dispositif de détermination peut être intégré au sein d'un ordinateur. Cet ordinateur peut notamment être embarqué et constituer ainsi un système électronique embarqué. Il peut s'agir par exemple d'un système électronique embarqué comportant un microcontrôleur ou à base de microcontrôleur.

Le système électrochimique peut comprendre notamment les organes auxiliaires de la pile à combustible.

BREVE DESCRIPTION DES DESSINS

L'invention sera bien comprise et ses avantages apparaîtront mieux à la lecture de la description détaillée qui suit, de modes de réalisation représentés à titre d'exemples non limitatifs. La description se réfère aux dessins annexés, sur lesquels :

- la figure 1 est une vue schématique d'une pile à combustible équipée d'un dispositif de détermination du régime de fonctionnement de la pile conforme à l'invention ;
- la figure 2 est un logigramme présentant de manière schématique les étapes d'une méthode selon l'invention permettant de configurer un classifieur

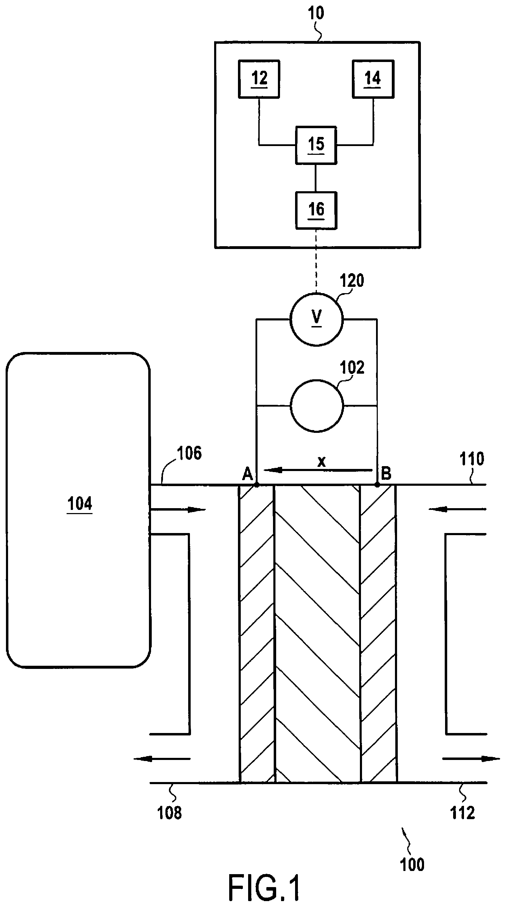

- la figure 1 est une vue schématique d'une pile à combustible équipée d'un dispositif de détermination du régime de fonctionnement de la pile conforme à l'invention ;

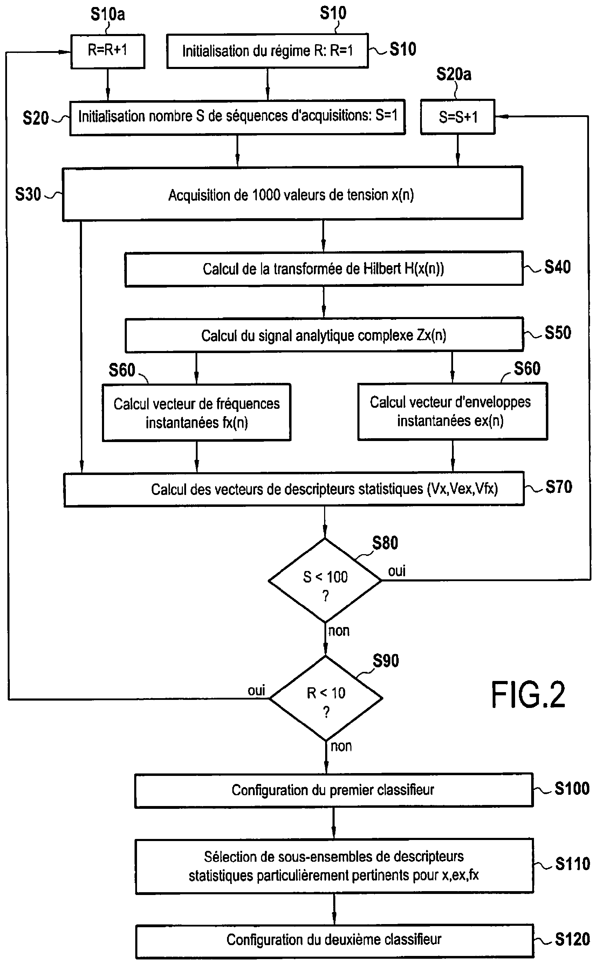

- la figure 2 est un logigramme présentant de manière schématique les étapes d'une méthode selon l'invention permettant de configurer un classifieur pour rendre celui-ci apte à déterminer le régime de fonctionnement de la pile de la figure 1 ;

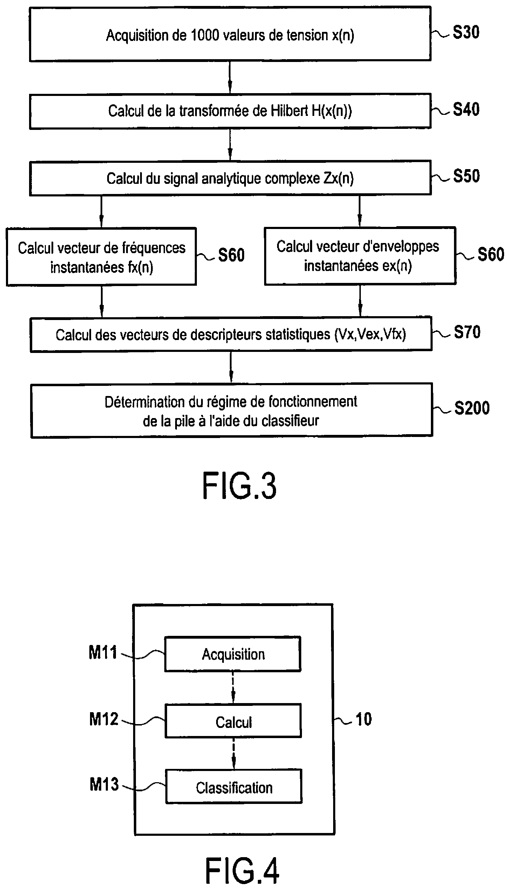

- la figure 3 est un logigramme présentant de manière schématique les étapes d'une méthode mise en oeuvre par le dispositif de détermination de la pile de la figure 1 et permettant, conformément à l'invention, de déterminer le régime de fonctionnement de la pile de la figure 1 ; et
- la figure 4 est une vue schématique de l'architecture fonctionnelle du dispositif de détermination de la pile représentée sur la figure 1.

DESCRIPTION DETAILLEE DE L'INVENTION

En faisant référence aux différentes figures, un dispositif 10 de détermination de régime de fonctionnement d'un système, en l'occurrence un système électrochimique, et un système électrochimique 100 comportant le dispositif 10, vont maintenant être décrits.

Le système électrochimique 100 est constitué principalement par une pile à combustible également référencée 100. Dans l'exemple présenté, une charge 102 est reliée en série avec les bornes A et B de la pile 100. La pile 100 alimente donc la charge 102 en électricité. Cette charge peut être un moteur électrique, une lampe électrique, etc.

De manière connue en soi, la pile 100 est alimentée en hydrogène par un réservoir 104 via une conduite 106. L'hydrogène non consommé est rejeté via une conduite 108. L'air, dont l'oxygène est utilisé comme comburant, pénètre dans la pile via une conduite 110. L'air appauvri en oxygène mais enrichi en eau est rejeté par une conduite 112.

La tension x aux bornes A et B de la pile 100 est mesurée par un voltmètre 120.

Le voltmètre 120 transmet les valeurs de la tension x mesurées au dispositif 10.

La pile 100 peut être exploitée dans différents régimes de fonctionnement, en fonction des conditions dans lesquelles elle est mise en oeuvre. Le fonctionnement de la pile 100 dépend ainsi notamment :

- du courant de charge de la pile en mode galvanostatique ;
- de la température de la pile ;
- des débits et pressions d'entrée et de sortie dans les conduites respectivement 106,110 et 108,112 ;
- du taux d'humidité (ou teneur en eau) des réactifs d'alimentation de la pile circulant dans les conduites 106 et 110.

Ces paramètres sont les principaux paramètres de fonctionnement de la pile. A chaque régime de fonctionnement de la pile 100 correspondent donc certaines plages de valeur pour les différents paramètres de fonctionnement de la pile.

Le but principal de l'invention est de pouvoir déterminer, dans quel régime de fonctionnement se trouve (ou se trouvait) la pile, à partir de mesures simples.

Dans le cas présent, le dispositif 10 permet de déterminer le régime de fonctionnement de la pile simplement à partir des valeurs de tension x mesurées aux bornes de la pile. Les régimes de fonctionnement que le dispositif 10 va permettre d'identifier sont donc différents régimes de fonctionnement correspondant à différentes valeurs ou plages de valeur des paramètres de fonctionnement de la pile.

Sur le plan matériel, le dispositif 10 est un dispositif de calcul, en l'occurrence un ordinateur. Le dispositif 10 peut être disposé à proximité de la pile 100, ou il peut être placé à distance de celle-ci. Il peut par exemple être constitué principalement par un ou plusieurs serveurs accessibles via internet ou autre, par liaison filaire ou sans fil.

L'architecture matérielle du dispositif 10 est illustrée schématiquement sur la figure 1. Il comprend notamment un processeur 15, une mémoire vive 12, une mémoire morte 14, ainsi que des moyens de communication 16 avec le voltmètre 120. Ces composants sont éventuellement partagés avec d'autres éléments de contrôle de la pile 100.

La mémoire morte 14 du dispositif 10 constitue un support d'enregistrement conforme à l'invention, lisible par le processeur 15 et sur lequel est enregistré un programme d'ordinateur C, conforme à l'invention, comportant des instructions pour l'exécution des étapes d'une méthode de détermination de régime de fonctionnement de la pile conforme à l'invention. Ces étapes sont décrites ci-dessous en référence à la figure 3.

Le programme C comporte notamment un programme de classification.

Pour que le dispositif 10 puisse déterminer le régime de fonctionnement de la pile 100, il faut d'abord configurer ce programme de classification. Le programme C comporte donc également des instructions pour l'exécution d'une méthode de configuration de classifieur conforme à l'invention.

Le programme de classification intégré au programme C doit être potentiellement capable, une fois configuré, d'identifier le régime de fonctionnement de la pile parmi les différents régimes de fonctionnement possibles de la pile, en fonction des valeurs de trois vecteurs de descripteurs statistiques Vx, Vex et Vfx.

Chacun de ces vecteurs Vx, Vex et Vfx comprend les descripteurs statistiques suivants : la valeur maximale (max), la valeur minimale (min), la moyenne ($\mu$), l'écart-type (a), le coefficient de variation (CV), la médiane (Med), le biais (Skew), le kurtosis (Kur).

Ces descripteurs statistiques sont obtenus à partir des données suivantes :

- le vecteur Vx comprend les descripteurs statistiques calculés à partir du vecteur des tensions x acquises ;
- le vecteur Vex comprend les descripteurs statistiques calculés à partir du vecteur ex des enveloppes instantanées calculées à partir du vecteur des tensions x acquises ; et
- le vecteur Vfx comprend les descripteurs statistiques calculés à partir du vecteur fx des fréquences instantanées calculées à partir du vecteur des tensions x acquises.

Le programme de classification, lorsqu'il est exécuté, exécute un algorithme de classification de type SVM multi-classes.

Pour pouvoir être mis en oeuvre, ce programme de classification doit préalablement être configuré. Sa configuration est réalisée de la manière suivante :

Tout d'abord, on définit les différents régimes de fonctionnement que l'on cherche à identifier ; chacun de ces régimes de fonctionnement est défini par des valeurs ou des plages de valeurs des paramètres de fonctionnement de la pile 100. Dans l'exemple présenté, on identifie dix régimes de fonctionnement, indexés par un index R variant de 1 à 10.

Ensuite, pour chacun de ces régimes de fonctionnement, on procède aux opérations suivantes :

- Pour le premier des dix régimes, à l'étape S10, l'index R est initialisé à la valeur 1, et le système électrochimique est placé dans le premier des dix régimes de fonctionnement identifiés. Cela consiste donc à faire fonctionner la pile en imposant que ses paramètres de fonctionnement aient des valeurs correspondant au premier régime de fonctionnement identifié.
- Pour les régimes suivants, (pour chaque nouvelle valeur de R), dans une étape S10a, on place le système électrochimique dans un nouveau régime parmi les dix régimes de fonctionnement identifiés, et on incrémente la valeur de R.

Pour chacun des dix régimes de fonctionnement, on réalise un certain nombre de fois, en l'occurrence cent fois de suite, une même séquence d'acquisition. Les séquences d'acquisition sont indexées par un index S. A l'étape S20, l'index S est initialisé à la valeur 1. Le fait d'obtenir un relativement grand nombre de données permet de disposer d'une base de données riche, ce qui est important pour pouvoir configurer le programme de classification de manière fiable.

Pour les itérations suivantes, (pour chaque nouvelle valeur de S), dans une étape S20a, on incrémente la valeur de S, tout en laissant le système électrochimique fonctionner dans le régime de fonctionnement en cours.

Pour chaque séquence d'acquisition, on réalise les opérations suivantes :

Le système électrochimique reste placé dans l'un des dix régimes de fonctionnement identifiés.

Pendant que la pile est dans ce régime de fonctionnement, on acquiert un vecteur x(n) de 1000 valeurs de la tension x (la tension x est donc dans cet exemple la variable représentant l'état du système 100) à 1000 instants ou pas de temps successifs (étape S30).

On calcule le vecteur ex(n) contenant les 1000 valeurs de l'enveloppe instantanée ex à partir du vecteur x(n) acquis à l'étape S30.

On calcule le vecteur fx(n) contenant les 1000 valeurs de la fréquence instantanée fx à partir du vecteur x acquis à l'étape S30.

Les vecteurs ex(n) des enveloppes instantanées et fx(n) des fréquences instantanées peuvent être obtenus de différentes manières.

Dans le cas présent, ils sont calculés de la manière suivante :

Dans une étape S40, on calcule la transformée de Hilbert H(x(n)) du vecteur de tension x(n). La transformée de Hilbert mentionnée ici est naturellement la transformée de Hilbert discrète.

Dans une étape S50, on calcule le signal analytique complexe Zx(n) à partir de la transformée de Hilbert H(x(n)) ainsi calculée, en utilisant la formule :

$$Zx(n) = x(n) + jH(x(n))$$

Dans une étape S60, on calcule alors le vecteur d'enveloppes instantanées ex(n) et le vecteur de fréquences instantanées fx(n) à partir du signal analytique complexe Zx(n) ainsi calculé.

L'enveloppe ou l'amplitude instantanée, qui est égale au module du signal analytique Zx(n), est définie par la relation :

$$ex(n) = |Zx(n)|$$

La fréquence instantanée fx, qui est la dérivée de la phase du signal analytique Zx(n), est définie par la relation :

$$fx\ (n) = \frac{1}{2\pi} \frac{d(arg(Zx\ ))}{dn}(n)$$

Grâce aux formules ci-dessus, pour chaque valeur de tension x acquise à l'instant n, on peut calculer une enveloppe instantanée ex et une fréquence fx, ce qui permet de calculer le vecteur ex(n) des enveloppes instantanées et le vecteur fx(n) des fréquences instantanées.

Les étapes S40, S50 et S60 permettent donc d'obtenir, pour chacun des vecteurs x(n) de tensions x acquis, le vecteur ex(n) d'enveloppes instantanées et le vecteur fx(n) de fréquences instantanées.

Ainsi, pour chaque acquisition de valeurs de tension réalisée, on obtient un triplet de vecteurs (x(n),ex(n),fx(n)), qui correspond à un régime de fonctionnement de la pile bien identifié (le régime dans lequel se trouvait la pile lorsque les valeurs de tension x(n) ont été acquises).

Ensuite, dans une étape S70 :

- on calcule le vecteur Vx des valeurs des descripteurs statistiques choisis pour le vecteur de tension x(n) ;
- on calcule le vecteur Vex des valeurs des descripteurs statistiques choisis pour le vecteur de fréquences instantanées ex(n) ; et
- on calcule le vecteur Vfx des valeurs des descripteurs statistiques choisis pour le vecteur d'enveloppes instantanées fx(n).

On obtient donc des triplets de vecteurs (Vx, Vex, Vfx).

On vérifie alors la valeur de l'indice S : Si S reste inférieur à 100 on poursuit ces séquences d'acquisitions, en incrémentant S (étape S20a).

Dans le cas contraire, on vérifie alors la valeur de l'indice R : Si R reste inférieur à 10 on poursuit les séquences d'acquisitions, en incrémentant R (étape S10a).

A l'issue de ces acquisitions, on obtient une base de données comprenant tous les triplets de vecteurs (Vx,Vex,Vfx) ainsi calculés.

Comme chacun de ces triplets est associé à un régime de fonctionnement connu, dans une étape S100, cette base permet alors de configurer le classifieur 10 ou plus précisément, le programme de classification contenu dans le programme C de détermination de régime de fonctionnement. Grâce à cette étape de configuration, à l'issue de l'étape S100, on dispose d'un classifieur apte, sur la base de vecteurs Vx, Vex et Vfx de descripteurs statistiques calculés à partir d'une séquence d'acquisition de la tension de la pile, à déterminer avec une probabilité élevée le régime de fonctionnement de la pile parmi les dix régimes de fonctionnement initialement identifiés.

Les étapes S110 et S120 présentées sur la figure 2 sont optionnelles et visent à obtenir un classifieur plus performant.

Dans ce but, par la méthode mRMR, on sélectionne dans une étape S110 un sous-ensemble de descripteurs statistiques particulièrement pertinents pour la tension, un sous-ensemble de descripteurs statistiques particulièrement pertinents pour l'enveloppe instantanée, et un sous-ensemble de descripteurs statistiques particulièrement pertinents pour la fréquence instantanée.

On charge dans le dispositif de calcul 10 un programme de classification apte, à partir d'une séquence d'acquisition de la tension de la pile, à déterminer avec un taux de reconnaissance ou un taux d'identification élevé le régime de fonctionnement de la pile parmi les dix régimes de fonctionnement identifiés, sur la base seulement d'un vecteur contenant ce sous-ensemble de descripteurs statistiques.

Dans une étape S120, on configure alors le programme de classification de telle sorte que pour chacun des dix régimes de fonctionnement choisis, et pour chaque triplet de vecteurs de descripteurs statistiques calculé à l'étape S110, le programme associe les valeurs des descripteurs statistiques calculées à l'étape S110 au régime de fonctionnement de la pile au moment où ces valeurs ont été enregistrées (de manière analogue à ce qui est fait à l'étape S100).

Le programme de classification qui est configuré à l'étape S100, et/ou celui qui est configuré à l'étape S120 peut être un classifieur de type SVM, ou un programme de classification contenant des instructions pour mettre en oeuvre la méthode 'des k plus proches voisins', ou la méthode GMM : 'Gaussian mixture model'.

Une fois ces opérations réalisées, le dispositif 10 constitue un classifieur au sens de l'invention, apte à partir des valeurs des descripteurs statistiques choisis pour la tension, l'enveloppe instantanée et la fréquence instantanée, à identifier le régime de fonctionnement dans lequel se trouvait la pile lorsque les valeurs de tension (ayant servi à déterminer les valeurs d'enveloppe instantanée et de fréquence instantanée) ont été enregistrées.

Le dispositif 10 peut être alors utilisé pour réaliser un diagnostic de la pile 100 en réalisant les opérations suivantes, présentées sur la figure 3 :

S30) on acquiert un vecteur contenant les N valeurs à N instants successifs de la tension aux bornes A et B de la pile 100 (N=1000).

S40-S50-S60) on calcule un vecteur d'enveloppes instantanées (ex(n)) et un vecteur de fréquences instantanées (fx(n)) à partir du vecteur x(n) de valeurs de tension ainsi acquis.

S70) alors, pour chacun des vecteurs de valeurs de tension, d'enveloppes instantanées, et de fréquences instantanées (x(n),ex(n),fx(n)), on calcule des valeurs des descripteurs statistiques (Vx,Vex,Vfx) choisis précédemment.

Les étapes S30, S40-S50-S60 et S80 citées ci-dessus sont identiques aux étapes correspondantes réalisées pour configurer le classifieur du dispositif 10, présentées précédemment.

Dans une étape S200, on identifie alors le régime de fonctionnement dans lequel se trouvait la pile lorsque le vecteur de tension ayant servi à calculer les vecteurs d'enveloppe instantanée et de fréquence instantanée a été enregistrée, en utilisant le classifieur 10 configuré de la manière indiquée précédemment.

De manière plus générale, la méthode de diagnostic peut être mise en oeuvre en utilisant, à l'étape S200 d'identification du régime de fonctionnement, n'importe quel classifieur apte à identifier le régime de fonctionnement de la pile en fonction des valeurs des descripteurs statistiques choisis, déterminées à partir du vecteur de tension acquis pendant la période considérée et des vecteurs d'enveloppes instantanées et de fréquences instantanées calculés à partir de ce vecteur de tension.

La structure fonctionnelle du dispositif 10, en tant que dispositif de diagnostic de système électrochimique, va maintenant être présentée en relation avec la figure 4.

Le dispositif 10 comporte :

- un module d'acquisition (M11), configuré pour acquérir des vecteurs de valeurs à N instants successifs d'une variable (x(n)) dont la valeur dépend d'un régime de fonctionnement du système ;
- un module de calcul (M12), configuré :

 pour calculer un vecteur d'enveloppes instantanées (ex(n)) et un vecteur de fréquences instantanées (fx(n)), à partir d'un vecteur x(n) de valeurs acquises ; et,
 pour chacun des vecteurs de valeurs acquises, d'enveloppes instantanées, et de fréquences instantanées, pour calculer un vecteur de valeurs de descripteurs statistiques (Vx,Vex,Vfx) ;

- un classifieur (M13), configuré pour déterminer un régime de fonctionnement dans lequel se trouvait le système électrochimique lorsqu'un vecteur de valeurs acquises (x(n)) a été acquis, parmi une pluralité de régimes de fonctionnement prédéterminés, en fonction des trois vecteurs Vx, Vfx et Vrx des descripteurs statistiques calculés à l'étape S70 respectivement pour les vecteurs de valeurs acquises, d'enveloppes instantanées, et de fréquences instantanées.

Dans le mode de réalisation décrit ici, les modules fonctionnels d'acquisition (M11), de calcul (M12), et le classifieur (M13) décrits précédemment sont des modules logiciels implémentés par le dispositif 10 pour réaliser la configuration du classifieur M13 ou la détermination du régime de fonctionnement de la pile 100, selon le cas.

La méthode présentée ci-dessus a été testée et a permis d'identifier des régimes de fonctionnement de la pile à combustible avec un taux de réussite très élevé (98%).

Le temps de calcul étant très court (de l'ordre de quelques millisecondes), la méthode peut être utilisée de manière prédictive.

Le système 10 peut donc être utilisé comme système de diagnostic, pour identifier en temps réel des dysfonctionnements de la pile.

Ainsi, dans le cas où la pile se met à fonctionner dans un régime de fonctionnement qui pourrait conduire à son endommagement, dès que ce régime de fonctionnement a été identifié, on applique à la pile ou plutôt au système à pile à combustible, et notamment aux organes auxiliaires de la pile comme son système d'alimentation en air et en hydrogène, une commande entraînant une modification du mode de fonctionnement de la pile, de manière à éviter que celle-ci ne soit endommagée.

Avantageusement, cette commande est appliquée avant même que les conséquences négatives ne surviennent, c'est-à-dire avant même que la pile ne soit endommagée.

**Revendications**

1. Méthode de configuration d'un classifieur pour rendre celui-ci apte à déterminer un régime de fonctionnement d'un système comprenant une pile à combustible, parmi une pluralité de régimes de fonctionnement prédéterminés dudit système,

   la méthode étant mise en oeuvre par ordinateur et comprenant d'une part, au moins une fois pour chaque régime parmi ladite pluralité de régimes de fonctionnement prédéterminés, les étapes suivantes :

   (S30) une acquisition d'un vecteur de valeurs à N instants successifs d'une variable (x) dont la valeur dépend d'un régime de fonctionnement du système, et la variable étant une tension (x) mesurée à des bornes (A,B) de la pile à combustible (100) ;
   (S40,S50,S60) un calcul d'un vecteur d'enveloppes instantanées (ex(n)) et d'un vecteur de fréquences instantanées (fx(n)) à partir du vecteur de valeurs acquises ;
   (S70) pour chacun des vecteurs de valeurs acquises, d'enveloppes instantanées, et de fréquences instantanées, un calcul d'un vecteur de valeurs de descripteurs statistiques ;

   la méthode comprenant en outre l'étape suivante :
   (S100) configuration d'un premier classifieur de telle sorte que celui-ci associe à chacun des vecteurs de valeurs de descripteurs statistiques calculés à l'étape S70, le régime de fonctionnement dans lequel se trouvait le système lorsque le vecteur de valeurs acquises qui a permis de calculer le vecteur de descripteurs statistiques considéré a été acquis.

2. Méthode de configuration d'un classifieur selon la revendication 1, dans laquelle le classifieur configuré à l'étape S100 est un classifieur à apprentissage automatique, et l'étape S100 est réalisée par apprentissage automatique.

3. Méthode de configuration d'un classifieur selon la revendication 1 ou 2, dans laquelle le classifieur configuré à l'étape S100 est un classifieur de type SVM, ou met en oeuvre la méthode des k plus proches voisins, ou la méthode Gaussian mixture model (GMM).

4. Méthode de détermination d'un régime de fonctionnement d'un système comprenant une pile à combustible, mise en oeuvre par ordinateur et comportant les étapes suivantes :

   S30) acquisition d'un vecteur de valeurs à N instants successifs d'une variable (x) dont la valeur dépend d'un régime de fonctionnement du système, ladite variable étant une tension (x) mesurée à des bornes (A,B) de la pile à combustible (100 ;
   S40-S50-S60) calcul d'un vecteur d'enveloppes instantanées (ex(n)) et d'un vecteur de fréquences instantanées (fx(n)) à partir du vecteur de valeurs acquises;
   S70) pour chacun des vecteurs de valeurs acquises, d'enveloppes instantanées, et de fréquences instantanées, calcul d'un vecteur de descripteurs statistiques ;
   S200) détermination alors du régime de fonctionnement dans lequel se trouvait le système lorsque le vecteur de valeurs acquises (x(n)) a été acquis, en mettant en oeuvre un classifieur configuré pour déterminer un régime de fonctionnement du système parmi une pluralité de régimes de fonctionnement prédéterminés de celui-ci, en fonction desdits trois vecteurs de descripteurs statistiques calculés respectivement pour les vecteurs de valeurs acquises, d'enveloppes instantanées, et de fréquences instantanées.

5. Méthode de détermination selon la revendication 4, dans laquelle l'étape de calcul de vecteurs d'enveloppes instantanées et de fréquences instantanées comporte les étapes suivantes :

(S40) calcul de la transformée de Hilbert H(x(n)) du vecteur de valeurs acquises x(n) ;
(S50) calcul du signal analytique complexe Zx(n) à partir de la transformée de Hilbert H(x(n)) ainsi calculée, en utilisant la formule :

$$Zx(n) = x(n) + jH(x(n))$$

(S60) calcul alors du vecteur d'enveloppes instantanées (ex(n)) et du vecteur de fréquences instantanées (fx(n)) à partir du signal analytique complexe Zx(n) ainsi calculé.

6. Méthode de détermination selon la revendication 4 ou 5, dans laquelle les descripteurs statistiques d'un vecteur de descripteurs statistiques calculé à l'étape S70 sont choisis parmi la moyenne, la variance, la médiane, le kurtosis, le maximum, le minimum, l'écart-type, le coefficient de variation.

7. Méthode de détermination selon l'une quelconque des revendications 4 à 6, dans laquelle le classifieur mis en oeuvre à l'étape S200 met en oeuvre un algorithme de type Supports Vectors Machines multiclasses.

8. Méthode de détermination selon l'une quelconque des revendications 4 à 7, dans laquelle le classifieur mis en oeuvre à l'étape S200 est un classifieur créé par la méthode selon l'une quelconque des revendications 1 à 3.

9. Programme d'ordinateur sur un support d'informations, ce programme étant susceptible d'être mis en oeuvre dans un ordinateur, ce programme comportant des instructions de code de programme pour l'exécution des étapes de la méthode de détermination selon l'une quelconque des revendications 4 à 8 ou de la méthode de configuration de classifieur selon l'une quelconque des revendications 1 à 3 lorsque ledit programme est exécuté sur un ordinateur.

10. Support d'informations (14) non volatiles lisible par un ordinateur sur lequel est enregistré un programme d'ordinateur selon la revendication 9.

11. Système (100) électrochimique comprenant une pile à combustible et équipé d'un dispositif de détermination (10) pour déterminer un régime de fonctionnement du système, le dispositif de détermination (10) comportant :

- un module d'acquisition (M11), configuré pour acquérir des vecteurs de valeurs à N instants successifs d'une variable (x) dont la valeur dépend d'un régime de fonctionnement du système, la variable étant une tension (x) mesurée à des bornes (A,B) de la pile à combustible (100) ;
- un module de calcul (M12), configuré :

pour calculer un vecteur d'enveloppes instantanées (ex(n)) et un vecteur de fréquences instantanées (fx(n)), à partir d'un vecteur x(n) de valeurs acquises ; et,
pour chacun des vecteurs de valeurs acquises, d'enveloppes instantanées, et de fréquences instantanées, pour calculer un vecteur de valeurs de descripteurs statistiques (Vx,Vex,Vfx) ;

- un classifieur (M13), configuré pour déterminer un régime de fonctionnement dans lequel se trouvait le système lorsqu'un vecteur de valeurs acquises (x(n)) a été acquis, parmi une pluralité de régimes de fonctionnement prédéterminés, en fonction des trois vecteurs (Vx,Vex,Vfx) de ladite pluralité de descripteurs statistiques calculés par le module de calcul respectivement pour les vecteurs (x(n)) de valeurs acquises, (ex(n)) d'enveloppes instantanées, et (fx(n)) de fréquences instantanées.

12. Système (100) électrochimique selon la revendication 11, dans laquelle le classifieur est un classifieur de type SVM, ou met en oeuvre la méthode des k plus proches voisins, ou la méthode Gaussian mixture model (GMM).

13. Système (100) électrochimique selon la revendication 11 ou 12, dans laquelle le module de calcul, pour le calcul des vecteurs d'enveloppes instantanées et de fréquences instantanées, réalise les étapes suivantes :

(S40) calcul de la transformée de Hilbert H(x(n)) du vecteur de valeurs acquises x(n) ;
(S50) calcul du signal analytique complexe Zx(n) à partir de la transformée de Hilbert H(x(n)) ainsi calculée, en utilisant la formule :

$$Zx(n) = x(n) + jH(x(n))$$

(S60) calcul alors du vecteur d'enveloppes instantanées (ex(n)) et du vecteur de fréquences instantanées (fx(n)) à partir du signal analytique complexe Zx(n) ainsi calculé.

**14.** Système (100) électrochimique selon l'une quelconque des revendications 11 à 13, dans laquelle les descripteurs statistiques du vecteur de valeurs de descripteurs statistiques sont choisis parmi la moyenne, la variance, la médiane, le kurtosis, le maximum, le minimum, l'écart-type, le coefficient de variation.

**15.** Système (100) électrochimique selon l'une quelconque des revendications 11 à 14, dans laquelle le classifieur est un classifieur créé par la méthode selon l'une quelconque des revendications 1 à 3.

**Patentansprüche**

**1.** Verfahren zur Konfiguration eines Klassifizierers, um ihn dazu geeignet zu machen, einen Betriebszustand eines Systems, das eine Brennstoffzelle umfasst, aus mehreren vorbestimmten Betriebszuständen des Systems zu bestimmen,

wobei das Verfahren per Computer umgesetzt wird und einerseits mindestens einmal für jeden Zustand aus den mehreren vorbestimmten Betriebszuständen die folgenden Schritte umfasst:

(S30) Erfassen eines Vektors von Werten mit N aufeinanderfolgenden Zeitpunkten einer Variablen (x), deren Wert von einem Betriebszustand des Systems abhängt, und wobei die Variable eine Spannung (x) ist, die an Anschlüssen (A, B) der Brennstoffzelle (100) gemessen wird,
(S40, S50, S60) Berechnen eines Vektors von momentanen Einhüllenden (ex(n)) und eines Vektors von momentanen Frequenzen (fx(n)) aus dem Vektor von erfassten Werten,
(S70) für jeden der Vektoren von erfassten Werten, von momentanen Einhüllenden und von momentanen Frequenzen, Berechnen eines Vektors von Werten von statistischen Deskriptoren,

wobei das Verfahren ferner den folgenden Schritt umfasst:
(S100) Konfigurieren eines ersten Klassifizierers, sodass dieser jedem der Vektoren von Werten von statistischen Deskriptoren, die in Schritt S70 berechnet werden, den Betriebszustand zuordnet, in dem sich das System befunden hat, als der Vektor von erfassten Werten, der ermöglicht hat, den betrachteten Vektor von statistischen Deskriptoren zu berechnen, erfasst worden ist.

**2.** Verfahren zur Konfiguration eines Klassifizierers nach Anspruch 1, wobei der in Schritt S100 konfigurierte Klassifizierer ein Klassifizierer mit maschinellem Lernen ist und Schritt S100 durch maschinelles Lernen umgesetzt wird.

**3.** Verfahren zur Konfiguration eines Klassifizierers nach Anspruch 1 oder 2, wobei der in Schritt S100 konfigurierte Klassifizierer ein Klassifizierer vom Typ SVM ist oder das Verfahren der k-nächsten Nachbarn oder das Verfahren des Gaußschen Mischmodells (GMM) umsetzt.

**4.** Verfahren zur Bestimmung eines Betriebszustands eines Systems, das eine Brennstoffzelle umfasst, per Computer umgesetzt und die folgenden Schritte beinhaltend:

S30) Erfassen eines Vektors von Werten mit N aufeinanderfolgenden Zeitpunkten einer Variablen (x), deren Wert von einem Betriebszustand des Systems abhängt, wobei die Variable eine Spannung (x) ist, die an Anschlüssen (A, B) der Brennstoffzelle (100) gemessen wird,
S40-S50-S60) Berechnen eines Vektors von momentanen Einhüllenden (ex(n)) und eines Vektors von momentanen Frequenzen (fx(n)) aus dem Vektor von erfassten Werten,
S70) für jeden der Vektoren von erfassten Werten, von momentanen Einhüllenden und von momentanen Frequenzen, Berechnen eines Vektors von statistischen Deskriptoren,
S200) anschließend Bestimmen des Betriebszustands, in dem sich das System befunden hat, als der Vektor von erfassten Werten (x(n)) erfasst worden ist, indem ein Klassifizierer umgesetzt wird, der dazu ausgestaltet ist, einen Betriebszustand des Systems aus mehreren vorbestimmten Betriebszuständen davon in Abhängigkeit der drei Vektoren der statistischen Deskriptoren, die jeweils für die Vektoren von erfassten Werten, von momentanen Einhüllenden und von momentanen Frequenzen berechnet werden, zu bestimmen.

5. Verfahren zur Bestimmung nach Anspruch 4, wobei der Schritt des Berechnens von Vektoren von momentanen Einhüllenden und von momentanen Frequenzen die folgenden Schritte beinhaltet:

(S40) Berechnen der Hilbert-Transformation H(x(n)) des Vektors von erfassten Werten x(n),
(S50) Berechnen des komplexen analytischen Signals Zx(n) aus der so berechneten Hilbert-Transformation H(x(n)) unter Verwendung der Formel:

$$Zx(n) = x(n) + jH(x(n))$$

(S60) anschließend Berechnen des Vektors von momentanen Einhüllenden (ex(n)) und des Vektors von momentanen Frequenzen (fx(n)) aus dem so berechneten komplexen analytischen Signal Zx(n).

6. Verfahren zur Bestimmung nach Anspruch 4 oder 5, wobei die statistischen Deskriptoren eines in Schritt S70 berechneten Vektors von statistischen Deskriptoren aus Durchschnitt, Varianz, Median, Wölbung, Maximum, Minimum, Standardabweichung, Variationskoeffizienten ausgewählt sind.

7. Verfahren zur Bestimmung nach einem der Ansprüche 4 bis 6, wobei der in Schritt S200 umgesetzte Klassifizierer einen Algorithmus vom Typ Multiklassen-Support-Vector-Machines umsetzt.

8. Verfahren zur Bestimmung nach einem der Ansprüche 4 bis 7, wobei der in Schritt S200 umgesetzte Klassifizierer ein Klassifizierer ist, der durch das Verfahren nach einem der Ansprüche 1 bis 3 erzeugt wird.

9. Computerprogramm auf einem Datenträger, wobei dieses Programm dazu ausgelegt ist, in einem Computer umgesetzt zu werden, wobei dieses Programm Programmcodeanweisungen zur Ausführung der Schritte des Verfahrens zur Bestimmung nach einem der Ansprüche 4 bis 8 oder des Verfahrens zur Konfiguration eines Klassifizierers nach einem der Ansprüche 1 bis 3 beinhaltet, wenn das Programm auf einem Computer ausgeführt wird.

10. Nichtflüchtiger Datenträger (14), der durch einen Computer lesbar ist, auf dem ein Computerprogramm nach Anspruch 9 aufgezeichnet ist.

11. Elektrochemisches System (100), umfassend eine Brennstoffzelle und mit einer Bestimmungsvorrichtung (10) zum Bestimmen eines Betriebszustands des Systems ausgestattet, wobei die Bestimmungsvorrichtung (10) beinhaltet:

- ein Erfassungsmodul (M11), das dazu ausgestaltet ist, Vektoren von Werten mit N aufeinanderfolgenden Zeitpunkten einer Variablen (x) zu erfassen, deren Wert von einem Betriebszustand des Systems abhängt, wobei die Variable eine Spannung (x) ist, die an Anschlüssen (A, B) der Brennstoffzelle (100) gemessen wird,
- ein Berechnungsmodul (M12), das ausgestaltet ist:

zum Berechnen eines Vektors von momentanen Einhüllenden (ex(n)) und eines Vektors von momentanen Frequenzen (fx(n)) aus einem Vektor x(n) von erfassten Werten, und
für jeden der Vektoren von erfassten Werten, von momentanen Einhüllenden und von momentanen Frequenzen, zum Berechnen eines Vektors von Werten von statistischen Deskriptoren (Vx, Vex, Vfx),

- einen Klassifizierer (M13), der dazu ausgestaltet ist, einen Betriebszustand, in dem sich das System befunden hat, als ein Vektor von erfassten Werten (x(n)) erfasst worden ist, aus mehreren vorbestimmten Betriebszuständen in Abhängigkeit der drei Vektoren (Vx, Vex, Vfx) aus den mehreren statistischen Deskriptoren, die durch das Berechnungsmodul jeweils für die Vektoren (x(n)) von erfassten Werten, (ex(n)) von momentanen Einhüllenden und (fx(n)) von momentanen Frequenzen berechnet werden, zu bestimmen.

12. Elektrochemisches System (100) nach Anspruch 11, wobei der Klassifizierer ein Klassifizierer vom Typ SVM ist oder das Verfahren der k-nächsten Nachbarn oder das Verfahren des Gaußschen Mischmodells (GMM) umsetzt.

13. Elektrochemisches System (100) nach Anspruch 11 oder 12, wobei das Berechnungsmodul für die Berechnung der Vektoren von momentanen Einhüllenden und von momentanen Frequenzen die folgenden Schritte umsetzt:

(S40) Berechnen der Hilbert-Transformation H(x(n)) des Vektors von erfassten Werten x(n),

(S50) Berechnen des komplexen analytischen Signals Zx(n) aus der so berechneten Hilbert-Transformation H(x(n)) unter Verwendung der Formel:

$$Zx(n) = x(n) + jH(x(n))$$

(S60) anschließend Berechnen des Vektors von momentanen Einhüllenden (ex(n)) und des Vektors von momentanen Frequenzen (fx(n)) aus dem so berechneten komplexen analytischen Signal Zx(n).

14. Elektrochemisches System (100) nach einem der Ansprüche 11 bis 13, wobei die statistischen Deskriptoren des Vektors von Werten von statistischen Deskriptoren aus Durchschnitt, Varianz, Median, Wölbung, Maximum, Minimum, Standardabweichung, Variationskoeffizienten ausgewählt sind.

15. Elektrochemisches System (100) nach einem der Ansprüche 11 bis 14, wobei der Klassifizierer ein Klassifizierer ist, der durch das Verfahren nach einem der Ansprüche 1 bis 3 erzeugt wird.

## Claims

1. A method for configuring a classifier to make it able to determine an operating regime of a system comprising a fuel cell, among a plurality of predetermined operating regimes of said system,

   the method being implemented by computer and comprising, one the one hand, at least once for each regime among said plurality of predetermined operating regimes, the following steps:

   (S30) acquiring a vector of values at N successive instants of a variable (x) whose value depends on an operating regime of the system, and the variable being a voltage (x) measured at terminals (A, B) of the fuel cell (100);

   (S40, S50, S60) calculating a vector of instantaneous envelopes (ex(n)) and a vector of instantaneous frequencies (fx(n)) based on the vector of acquired values;

   (S70) for each of the vectors of acquired values, of instantaneous envelopes, and of instantaneous frequencies, calculating a vector of statistical descriptor values;

   the method comprising, on the other hand, the following step:

   (S100) configuring a first classifier such that it associates with each of the vectors of statistical descriptor values, calculated in step S70, the operating regime in which the system was when the vector of acquired values which made it possible to calculate the vector of statistical descriptors considered was acquired.

2. The method for configuring a classifier according to claim 1, wherein the classifier configured in step S100 is a machine learning classifier, and step S100 is carried out by machine learning.

3. The method for configuring a classifier according to claim 1 or 2, wherein the classifier configured in step S100 is an SVM type classifier, or implements the k-nearest neighbor method, or the Gaussian mixture model (GMM) method.

4. The method for determining an operating regime of a system comprising a fuel cell, implemented by computer and including the following steps:

   S30) acquiring a vector of values at N successive times of a variable (x) whose value depends on an operating regime of the system, said variable being a voltage (x) measured at terminals (A, B) of the fuel cell (100);

   S40-S50-S60) calculating a vector of instantaneous envelopes (ex(n)) and a vector of instantaneous frequencies (fx(n)) based on the vector of acquired values;

   S70) for each of the vectors of acquired values, of instantaneous envelopes, and of instantaneous frequencies, calculating a vector of statistical descriptors;

   S200) then determining the operating regime in which the system was when the vector of acquired values (x(n)) was acquired, by implementing a classifier configured to determine an operating regime of the system among a plurality of predetermined operating regimes thereof, as a function of said three vectors of statistical descriptors calculated respectively for the vectors of acquired values, of instantaneous envelopes, and of instantaneous frequencies.

5. The determination method according to claim 4, wherein the step of calculating vectors of instantaneous envelopes and of instantaneous frequencies includes the following steps:

(S40) calculating the Hilbert transform H(x(n)) of the vector of acquired values x(n);
(S50) calculating the complex analytical signal Zx(n) based on the thus calculated Hilbert transform H(x(n)), using the formula:

$$Zx(n) = x(n) + jH(x(n))$$

(S60) then calculating the vector of instantaneous envelopes (ex(n)) and the vector of instantaneous frequencies (fx(n)) based on the thus calculated complex analytical signal Zx(n).

6. The determination method according to claim 4 or 5, wherein the statistical descriptors of a vector of statistical descriptors, calculated in step S70, are chosen from the mean, the variance, the median, the kurtosis, the maximum, the minimum, the standard deviation, the coefficient of variation.

7. The determination method according to any one of claims 4 to 6, wherein the classifier implemented in step S200 implements a multiclass Supports Vectors Machines type algorithm.

8. The determination method according to any one of claims 4 to 7, wherein the classifier implemented in step S200 is a classifier created by the method according to any one of claims 1 to 3.

9. A computer program on an information medium, this program being capable of being implemented in a computer, this program including program code instructions for executing the steps of the determination method according to the any one of claims 4 to 8 or of the classifier configuration method according to any one of claims 1 to 3 when said program is executed on a computer.

10. A non-volatile information medium (14) readable by a computer on which a computer program according to claim 9 is recorded.

11. An electrochemical system (100) comprising a fuel cell and equipped with a determination device (10) for determining an operating regime of the system, the determination device (10) including:

- an acquisition module (M11), configured to acquire value vectors at N successive times of a variable (x) whose value depends on an operating regime of the system, the variable being a voltage (x) measured at terminals (A, B) of the fuel cell (100);
- a calculation module (M12), configured:

to calculate a vector of instantaneous envelopes (ex(n)) and a vector of instantaneous frequencies (fx(n)), based on a vector x(n) of acquired values; and,
for each of the vectors of acquired values, of instantaneous envelopes, and of instantaneous frequencies, to calculate a vector of statistical descriptor values (Vx, Vex, Vfx);

- a classifier (M13), configured to determine an operating regime in which the system was when a vector of acquired values (x(n)) was acquired, among a plurality of predetermined operating regimes, as a function of the three vectors (Vx, Vex, Vfx) of said plurality of statistical descriptors calculated by the calculation module respectively for the vectors (x(n)) of acquired values, (ex(n)) of instantaneous envelopes, and (fx(n)) of instantaneous frequencies.

12. The electrochemical system (100) according to claim 11, wherein the classifier is an SVM type classifier, or implements the k-nearest neighbor method, or the Gaussian mixture model (GMM) method.

13. The electrochemical system (100) according to claim 11 or 12, wherein the calculation module, for calculating the vectors of instantaneous envelopes and of instantaneous frequencies, carries out the following steps:

(S40) calculating the Hilbert transform H(x(n)) of the vector of acquired values x(n);
(S50) calculating the complex analytical signal Zx(n) based on the thus calculated Hilbert transform H(x(n)), using the formula:

$$Zx(n) = x(n) + jH(x(n))$$

(S60) then calculating the vector of instantaneous envelopes (ex(n)) and the vector of instantaneous frequencies (fx(n)) based on the thus calculated complex analytical signal Zx(n).

14. The electrochemical system (100) according to any one of claims 11 to 13, wherein the statistical descriptors of the vector of statistical descriptor values are chosen from the mean, the variance, the median, the kurtosis, the maximum, the minimum, the standard deviation, the coefficient of variation.

15. The electrochemical system (100) according to any one of claims 11 to 14, wherein the classifier is a classifier created by the method according to any one of claims 1 to 3.

FIG.1

S10a

R=R+1

S10

Initialisation du régime R: R=1 ⟩―S10

S20a

S=S+1

S20 ⟩ Initialisation nombre S de séquences d'acquisitions: S=1

S30 ⟩ Acquisition de 1000 valeurs de tension x(n)

Calcul de la transformée de Hilbert H(x(n)) ―S40

Calcul du signal analytique complexe Zx(n) ―S50

S60

Calcul vecteur de fréquences
instantanées fx(n)

S60

Calcul vecteur d'enveloppes
instantanées ex(n)

Calcul des vecteurs de descripteurs statistiques (Vx,Vex,Vfx) ―S70

S80

S < 100
?

oui

non

S90

R < 10
?

oui

non

FIG.2

Configuration du premier classifieur ―S100

Sélection de sous-ensembles de descripteurs
statistiques particulièrement pertinents pour x,ex,fx ―S110

Configuration du deuxième classifieur ―S120

```
┌─────────────────────────────────────────────────┐
│     Acquisition de 1000 valeurs de tension x(n)   │─── S30
└─────────────────────────────────────────────────┘
                        │
                        ▼
┌─────────────────────────────────────────────────┐
│       Calcul de la transformée de Hilbert H(x(n)) │─── S40
└─────────────────────────────────────────────────┘
                        │
                        ▼
┌─────────────────────────────────────────────────┐
│       Calcul du signal analytique complexe Zx(n)  │─── S50
└─────────────────────────────────────────────────┘
            │                          │
            ▼                          ▼
┌──────────────────────┐      ┌──────────────────────┐
│ Calcul vecteur de    │─S60  │ Calcul vecteur       │─S60
│ fréquences           │      │ d'enveloppes         │
│ instantanées fx(n)   │      │ instantanées ex(n)   │
└──────────────────────┘      └──────────────────────┘
            │                          │
            ▼                          ▼
┌─────────────────────────────────────────────────┐
│  Calcul des vecteurs de descripteurs statistiques │─── S70
│                (Vx,Vex,Vfx)                       │
└─────────────────────────────────────────────────┘
                        │
                        ▼
┌─────────────────────────────────────────────────┐
│       Détermination du régime de fonctionnement   │─── S200
│         de la pile à l'aide du classifieur        │
└─────────────────────────────────────────────────┘
```

# FIG.3

```
        ┌───────────────────────────────────┐
        │                                   │
M11 ────│     ┌───────────────────┐         │
        │     │   Acquisition      │         │
        │     └───────────────────┘         │
        │              ┊                    │
M12 ────│     ┌───────────────────┐         │─── 10
        │     │     Calcul         │         │
        │     └───────────────────┘         │
        │              ┊                    │
M13 ────│     ┌───────────────────┐         │
        │     │   Classification   │         │
        │     └───────────────────┘         │
        │                                   │
        └───────────────────────────────────┘
```

# FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **DE MME BENOUIOUA ; MM.D.CANDUSSO ; F.HAREL ; L.OUKHELLOU.** Multifractal Analysis of Stack Voltage BAsed on Wavelet Leaders : A new tool for PEMFC Diagnosis. *Fuell Cells,* 14 Juillet 2016, vol. 17 (2), 217-224
- **DE WEI LIU et al.** Applications of Hilbert-Hugon Transform and SVM to Coal Gangue Interface Détection. *Journal of computers,* 03 Juin 2011, vol. 6 (6
- **DE LU DINGGUO et al.** Adaptive feature extraction and SVM classification for real-time diagnosis of drivetrain gearboxes. *2013 IEEE Energy Conversion Congress and Exposition,* 15 Septembre 2013, 3934-3940